(19) Europäisches Patentamt European Patent Office Office européen des brevets

(11) **EP 4 087 010 B1**

(12) **EUROPEAN PATENT SPECIFICATION**

(45) Date of publication and mention of the grant of the patent:
**29.04.2026 Bulletin 2026/18**

(21) Application number: **21872744.4**

(22) Date of filing: **27.08.2021**

(51) International Patent Classification (IPC):
*H01M 10/42* (2006.01)   *G01N 9/20* (2006.01)
*G01F 23/20* (2006.01)   *G01R 31/385* (2019.01)
*H02J 7/00* (2026.01)   *G01N 9/02* (2006.01)

(52) Cooperative Patent Classification (CPC):
**G01N 9/02; G01F 23/20; G01N 9/08; G01N 9/10;
H01M 10/0525; H01M 10/48; H01M 50/242;
H01M 50/264; H01M 50/477; H02J 7/70;
Y02E 60/10**

(86) International application number:
**PCT/KR2021/011516**

(87) International publication number:
**WO 2022/065714 (31.03.2022 Gazette 2022/13)**

(54) **APPARATUS FOR MEASURING VOLUME OF A BATTERY CELL COMPRISING A BATTERY CELL JIG INCLUDING A SPACER AND METHOD FOR MEASURING VOLUME OF BATTERY CELL USING SAME**

GERÄT ZUM MESSEN DES VOLUMENS EINER BATTERIEZELLE MIT EINER BATTERIEZELLENVORRICHTUNG MIT ABSTANDHALTER, UND VERFAHREN ZUM MESSEN DES VOLUMENS EINER BATTERIEZELLE UNTER VERWENDUNG DERSELBEN

APPAREIL POUR MESURER LE VOLUME D'ÉLÉMENT DE BATTERIEG AVEC UN ABARIT D'ÉLÉMENT DE BATTERIE COMPRENANT UN ESPACEUR ET PROCÉDÉ DE MESURE DE VOLUME D'ÉLÉMENT DE BATTERIE L'UTILISANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.09.2020 KR 20200125775**

(43) Date of publication of application:
**09.11.2022 Bulletin 2022/45**

(73) Proprietor: **LG Energy Solution, Ltd.
Seoul 07335 (KR)**

(72) Inventors:
• **JEON, Hyung In
Daejeon 34122 (KR)**

• **KIM, Hye Jin
Daejeon 34122 (KR)**

(74) Representative: **Goddar, Heinz J.
Boehmert & Boehmert
Anwaltspartnerschaft mbB
Pettenkoferstrasse 22
80336 München (DE)**

(56) References cited:
CN-A- 111 504 414     JP-A- 2006 147 531
KR-A- 20160 067 235     KR-B1- 100 922 571
KR-B1- 100 922 571     KR-B1- 101 195 888
KR-B1- 102 070 684     US-A1- 2015 167 709

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 087 010 B1

# Description

[Technical Field]

This application claims the benefit of priority based on Korean Patent Application No. 10-2020-0125775, filed on September 28, 2020.

The present invention relates to a battery cell jig including a spacer, a battery cell volume measuring apparatus including the battery cell jig, and a battery cell volume measuring method performed by using the apparatus.

[Background Art]

Recently, secondary batteries capable of charging and discharging have been widely used as energy sources of wireless mobile devices. In addition, the secondary battery has attracted attention as an energy source of an electric vehicle, a hybrid electric vehicle, etc., which are proposed as a solution for air pollution of existing gasoline vehicles and diesel vehicles using fossil fuel. Therefore, the types of applications using the secondary battery are currently much diversified due to the advantages of the secondary battery, and it is expected that the secondary battery will be applied to many fields and products in the future.

Such secondary batteries may be classified into lithium ion batteries, lithium ion polymer batteries, lithium polymer batteries, etc., depending on the composition of the electrode and the electrolyte, and among them, the amount of use of lithium-ion polymer batteries that are less likely to leak electrolyte and are easy to manufacture is on the increase. In general, secondary batteries are classified into cylindrical batteries and prismatic batteries in which an electrode assembly is embedded in a cylindrical or rectangular metal can, depending on the shape of a battery case, and pouch-type batteries in which the electrode assembly is embedded in a pouch-type case of an aluminum laminate sheet. The electrode assembly built into the battery case is composed of a positive electrode, a negative electrode, and a separator interposed between the positive electrode and the negative electrode, and is a power generating element capable of charging and discharging. The electrode assembly is classified into a jelly-roll type wound with a separator interposed between the positive electrode and the negative electrode which are long sheet-shaped and are coated with active materials, and a stack type in which a plurality of positive electrodes and negative electrodes of a predetermined size are sequentially stacked while a separator is interposed therebetween.

Herein, as the capacity of the battery increases, the size of the case also increases and the processing of a thin material is drawing attention. As such, the amount of use of pouch-type batteries, which have a structure where a stack-type or stack/folding-type electrode assembly is built in a pouch-type battery case of an aluminum laminate sheet, gradually increases for the reasons of low manufacturing costs, a low weight, and an easy form modification, etc.

Such a secondary battery is degenerated as a large amount of gases are generated by electrolyte decomposition by repeated charge/discharge, and this aspect is differently shown depending on the battery design and used type. When the internal gas is continually generated in the battery, a swelling phenomenon, in which the volume of the battery increases, is observed, and when the internal pressure of the battery cell exceeds a critical point, the battery may be exploded. As such, it is essential to observe the volume change of the battery cell.

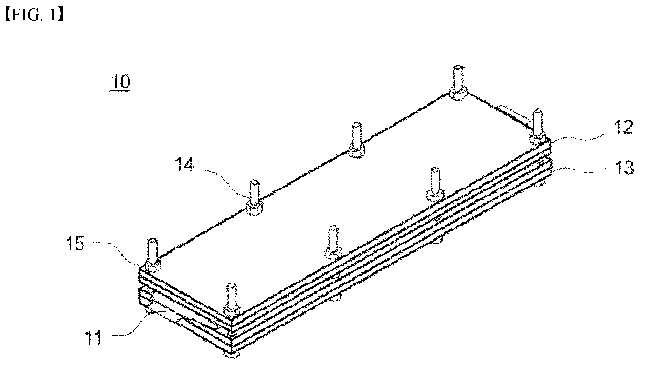

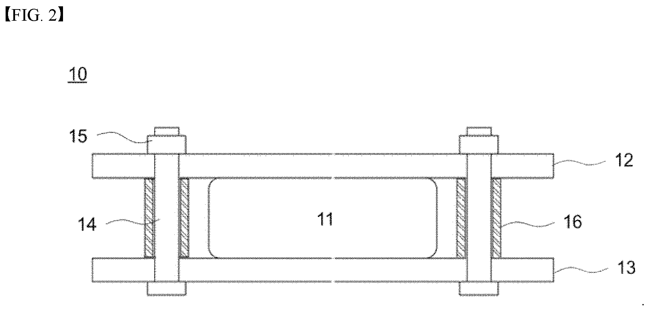

Conventionally, in order to observe the volume change of the battery cell, the volume change amount of the battery cell was measured using Archimedes principle. At this time, in order to press the battery cell, the battery cell was accommodated in a battery cell jig, and an experiment was then conducted. FIG. 1 is a schematic diagram of a conventional battery cell jig for evaluating performance of a secondary battery, and FIG. 2 is a right-side cross-sectional view (A-A') of the battery cell jig illustrated in FIG. 1. As shown in FIG. 1, the battery cell jig 10 performs bolt fastening using nuts 15 and bolts 14 which penetrate the first plate 12 and the second plate 13 to fix the battery cell 11. Further, since there has been a problem that the pressure applied to the battery cell 11 is different by locations according to the order of fastening the bolts 14 and nuts 15 or the worker's style, a method of minimizing the biased pressure application by locations or fastening errors by using spacers fitting the thickness of the battery cell 11 has been used as illustrated in FIG. 2.

However, when the volume change amount is measured using Archimedes principle in a state that the battery cell 11 is accommodated in the battery cell jig 10, inaccurate data may be obtained as water is stagnated in a space between the battery cell jig 10 and the spacer 16, which may lead to corrosion of the bolt 14 and the battery cell jig 10. As such, the volume of the battery cell should have been measured after disassembling the battery cell jig 10.

The document KR100922571B1 discloses a jig for a battery device known in the art.

[Disclosure]

[Technical Problem]

The present invention is believed to solve at least some of the above problems. For example, an aspect of the present invention provides a battery cell jig including a spacer, which is capable of preventing stagnation of water at a space between the battery cell jig and the spacer at the time of measuring a volume change of a battery cell, a battery cell volume measuring apparatus including the battery cell jig, and a battery cell volume measuring method performed by using the apparatus.

[Technical Solution]

The present invention provides a battery cell volume measuring apparatus including a battery cell jig as defined in claim 1.
In one embodiment, the slit of the spacer is opened from one side to the other side along the longitudinal direction.
In another embodiment, an angle of the slit of the spacer is in a range of 10 to 70 degrees from a center of an axis.
A height of the spacer may correspond to a height of the battery cell interposed between the first and second plates. Further, the battery **cell** jig may include 4 to 12 bolts and nuts, respectively, and the spacer may be fastened by at least one bolt.
Further, the present invention provides a battery cell volume measuring method performed by using the above-described battery **cell** volume measuring apparatus. In one embodiment, a method of measuring a volume of a battery cell according to the present invention is performed by interposing a battery **cell** in the battery cell jig and then measuring weights before and after a volume change of the battery cell, respectively.
In a specific example, the method includes: interposing the battery cell in the battery cell jig and then measuring the weight of the battery cell jig in the air; accommodating the battery cell jig in a water tank where liquid has been accommodated, and then measuring the weight of the battery cell jig in the liquid; and calculating a volume change amount of the battery cell by a following formula 1:

$$[Formula\ 1]$$

$$V = \frac{W1 - W2}{\rho}.$$

Herein, the V denotes the volume change amount of the battery cell, **W1** denotes the weight of the battery cell jig in the air, W2 denotes the weight of the battery cell jig accommodated in liquid, and $\rho$ denotes a density of the liquid.
At this time, the measuring of the weight of the battery cell jig in the liquid may comprise charging and discharging the battery cell.
Further, during the measuring of the weight of the battery cell jig in the air and the measuring of the weight of the battery cell jig in the liquid, the weight of the battery cell jig may be measured by using a spring scale.
**In** another embodiment, the measuring of the weight of the battery cell jig in the liquid may comprise heating the liquid to a predetermined temperature. At this time, the calculating a volume change amount of the battery cell may comprise calculating a volume change of the battery cell according to a temperature of the liquid.
Further, the liquid accommodated in the water tank may be water, ethanol or silicone oil.

[Advantageous Effects]

According to a battery cell jig including a spacer, a battery cell volume measuring apparatus including the battery cell jig, and a battery cell volume measuring method performed by using the apparatus of the present invention, it is possible to maintain a space between the first and second plates having a battery cell interposed therebetween constant.
Further, it is possible to preventing stagnation of water at a space between the battery cell jig and the spacer when measuring the volume change of the battery cell using Archimedes principle by including a slit opened along a longitudinal direction in the spacer.

[Brief Description of the Drawings]

FIG. 1 is a schematic diagram of a conventional battery cell jig for evaluating performance of a secondary battery.
FIG. 2 is a right-side cross-sectional view (A-A') of the battery cell jig illustrated in FIG. 1.
FIG. 3 is a right-side cross-sectional view of a battery cell jig including a spacer according to one embodiment of the present invention.
FIG. 4 is a right-side cross-sectional view of a battery cell jig including a spacer according to another embodiment of the present invention.
FIG. 5 is a block diagram illustrating each component of a battery cell volume measuring apparatus according to further another embodiment of the present invention.
FIG. 6 is a flowchart illustrating a method of measuring the volume of a battery cell according to further another embodiment of the present invention.

[Detailed Description of the Preferred Embodiments]

As the inventive concept allows for various changes and numerous embodiments, particular embodiments will be illustrated in the drawings and described in detail in the text. However, this is not intended to limit the present invention to the specific form disclosed, and it should be understood to include all changes, equivalents, and substitutes included in the spirit and scope of the present invention.
In this application, it should be understood that terms such as "include" or "have" are intended to indicate that there is a feature, number, step, operation, component, part, or a combination thereof described on the specification, and they do not exclude in advance the possibility of the presence or addition of one or more other features or numbers, steps, operations, components, parts or combinations thereof. Also, when a portion such as a layer, a film, an area, a plate, etc. is referred to as being "on" another portion, this includes not only the case where the portion is "directly on" the another portion but also the case where further another portion is interposed therebetween. On the other hand, when a portion such as a layer, a film, an area, a plate, etc. is referred to as being "under" another portion, this includes not only the case where the portion is "directly under" the another portion but also the case where further another portion is interposed therebetween. In addition, to be disposed "on" in the present application may include the case disposed at the bottom as well as the top.

The present invention provides a battery cell jig including a spacer, a battery cell volume measuring apparatus including the battery cell jig, and a battery cell volume measuring method performed by using the apparatus.

Conventionally, the volume change amount of the battery cell was measured using Archimedes principle. At this time, in order to press a battery cell, a battery cell was accommodated in a battery cell jig to perform an experiment, and in order to press the battery cell accommodated in the battery cell jig with uniform pressure, spacers corresponding to the thickness of the battery cell were used to minimize biased pressure application by locations and fastening errors. However, when the volume change amount is measured using Archimedes principle in a state that the battery cell is accommodated in the battery cell jig, inaccurate data may be obtained as water is stagnated in a space between the battery cell jig and the spacer, which may lead to corrosion of the bolt and the battery cell jig. As such, the volume of the battery cell should have been measured after disassembling the battery cell jig.

As such, the present invention provides a battery cell jig including a spacer, which is capable of preventing stagnation of water at a space between the battery cell jig and the spacer at the time of measuring a volume change of a battery cell, a battery cell volume measuring apparatus including the battery cell jig, and a battery cell volume measuring method performed by using the apparatus.

Specifically, according to a battery cell jig including a spacer, a battery cell volume measuring apparatus including the battery cell jig, and a battery cell volume measuring method performed by using the apparatus of the present invention, it is possible to maintain a space between the first and second plates having a battery cell interposed therebetween constant, and it is possible to preventing stagnation of water at a space between the battery cell jig and the spacer when measuring the volume change of the battery cell using Archimedes principle by including a slit opened along a longitudinal direction in the spacer.

In one embodiment, the present invention provides a battery cell jig including a spacer. In a specific example, a battery cell jig according to the present invention includes: first and second plates; a bolt and a nut which fix the first and second plates in a state that a battery cell is interposed between the first and second plates; and a spacer which is positioned between the first and second plates to designate a separation distance and have a structure of surrounding the bolt. At this time, the spacer includes a slit which is opened along a longitudinal direction of the spacer.

In the present invention, the "slit" refers to a gap formed along the longitudinal direction in the spacer and means an open region formed along the longitudinal direction of the spacer. Particularly, since the battery cell jig according to the present invention includes a slit in a spacer, it is possible to prevent stagnation of water or gas in the space at the time of measuring the volume change of a battery cell using Archimedes principle.

In one embodiment, a battery cell jig according to the present invention includes a spacer including a slit opened along a longitudinal direction. The spacer is used to maintain the distance between the first and second plates constant and has a structure of surrounding a bolt. The spacer may be made of aluminum.

Further, the slit of the spacer may be opened from one side to the other side along the longitudinal direction.

In a specific example, the spacer has a "C" shape when viewed based on a cross-section. It is possible to prevent water from stagnating in the spacer or gas from being filled in the spacer at the time of measuring the volume of a battery cell using Archimedes principle by a slit of such a spacer.

In another embodiment, a spacer including a slit opened along a longitudinal direction is provided. Specifically, the slit of the spacer may be opened in a range of 10 to 70 degrees from the center of the axis.

The slit of the spacer is opened in a range of 10 to 70 degrees from the center of the axis on the basis of the cross-section of the spacer. For example, the slit is opened by 60 degrees on average on the basis of the axis of the spacer. Since the slit is opened in the above-mentioned angle, it is possible to prevent water from stagnating or gas from being filled at a space between the battery cell jig and the spacer.

In another embodiment, when measuring the volume change of the battery cell using Archimedes principle, the volume change of the battery cell may be measured after the spacer is separated from the battery cell jig because the spacer is opened at the above-described angle.

Further, the first and second plates have a structure of pressing a battery cell while interposing the battery cell therebetween and are fastened by bolts and nuts in a state that the battery cell is interposed between the first and second plates. At this time, the first and second plates may be made of aluminum.

Further, the battery cell interposed between the first and second plates may be a pouch-type unit cell.

Specifically, the pouch type unit cell may have a structure that an electrode assembly having a positive electrode/ separator/ negative electrode structure is embedded in an exterior material of the laminate sheet in a state that is connected to electrode leads formed outside the exterior material. The electrode leads may be drawn to the outside of the sheet and may be extended in the same or opposite direction to each other.

In one embodiment, the battery cell jig according to the present invention includes a plurality of bolts and nuts. In a specific example, the battery cell jig according to the present invention includes 4 to 12 or 6 to 10 bolts and nuts, respectively. For example, the battery cell jig includes 10 bolts and nuts, respectively.

Further, the spacer may be fastened with at least one bolt. Namely, each of spacers is fastened to each of the plurality of bolts, and the spacers are fastened to have the same height. Further, each bolt and nut may be fastened with the same pressure.

In one embodiment, a height of the spacer may correspond to a height of the battery cell interposed between the first and second plates. As such, it is possible to easily adjust the space between the first and second plates. Specifically, the user allows a battery cell to be positioned at the second plate coupled with the bolt, and allows the spacer to be inserted into the bolt. And, after allowing the height of the battery cell to correspond to the height of the spacer laminate, the first plate may be coupled, and fastening may be performed by nuts.

In one embodiment, the battery cell jig according to the present invention includes a plurality of bolts and nuts. In particular, it is possible to minimize biased pressure or a fastening error, etc. per position by inserting the spacer having the same height into each bolt.

Further, the present invention provides a battery cell volume measuring apparatus including the above-described battery cell jig.

In one embodiment, an apparatus for measuring a volume of a battery cell according to the present invention includes: the battery cell jig; a water tank where liquid is accommodated therein; and a scale which measures a weight of the battery cell jig, where the battery cell has been accommodated, at an external side of the water tank and at an internal side of the water tank, respectively.

The apparatus for measuring the volume of a battery cell according to the present invention uses the principle of Archimedes. According to Archimedes principle, the buoyancy applied to an object which is fully or partially dipped in liquid works in a direction opposite to the direction of gravity by the same size as that of the weight of the liquid as much as the volume pushed aside by the object ($F=\rho gV=mg$, herein, F: buoyancy, $\rho$: density of liquid, V: volume of an object as much as the amount dipped in the liquid, g: acceleration of gravity, m: mass of object). At this time, the difference between the weight of the battery cell before being dipped in the liquid accommodated in the water tank and the weight of the battery cell after being dipped in the liquid may be the weight of the liquid which has increased in volume as the battery cell is dipped in the liquid. At this time, since the weight of the liquid, which is pushed aside as the battery cell is dipped in the liquid, is the same as the buoyancy, the volume of the battery cell can be recognized from the measured buoyancy. Namely, if the weight of the battery cell in the air and the weight of the battery cell in the liquid are found out, the volume of the battery cell can be calculated.

Likewise, according to the battery cell volume measuring apparatus of the present invention, it is possible to measure the volume of a battery cell in a non-destructive manner in a normal pressure by only measuring the weight of the battery cell without a process of punching or pressing the battery.

In one embodiment, the water tank has a space where liquid can be accommodated therein. There is no particular limitation to the type of liquid accommodated in the water tank. For example, water can be accommodated. Alternatively, liquid such as ethanol can be used, and electrically insulating liquid such as silicone oil can be used.

The battery cell jig fixes the battery cell in order to prevent a movement of the battery cell during the volume measurement. As described above, the battery cell jig includes: first and second plates; a bolt and a nut which fix the first and second plates in a state that a battery cell is interposed between the first and second plates; and a spacer which is positioned between the first and second plates to designate a separation distance and have a structure of surrounding the bolt. At this time, the spacer includes a slit which is opened along a longitudinal direction.

Further, the battery cell may be a pouch-type unit cell. Specifically, the pouch type unit cell may have a structure that an electrode assembly having a positive electrode/ separator/ negative electrode structure is embedded in an exterior material of the laminate sheet in a state that is connected to electrode leads formed outside the exterior material. The electrode leads may be drawn to the outside of the sheet and may be extended in the same or opposite direction to each other.

In addition, the scale is used to measure the weight of the battery cell jig having a battery cell accommodated therein, and the weight at the external side of the water tank of the battery cell jig and the weight in the liquid are measured. Herein, the weight at the external side of the water tank means the weight of the battery cell jig in the air. The scale may be a conventional scale for measuring a weight. For example, the scale may be a spring scale or an electronic scale.

In one example, the battery cell volume measuring apparatus further includes a charge and discharge unit which is electrically connected to the battery cell. The charge/discharge unit may supply power for charge to the secondary battery or receive discharge power from the secondary battery. Herein, supplying power to the secondary battery is not limited to supplying power which is sufficient for fully charging the secondary battery. Supplying power to the secondary battery may also mean supplying power which may be sufficient for measuring voltages of the first electrode lead and the second electrode lead to evaluate performance of the secondary battery. The same may be applied to the meaning of receiving discharge power from the secondary battery, and thus repeated description thereof is omitted here.

Further, the present invention provides a battery cell volume measuring method performed by using the above-described battery cell volume measuring apparatus.

In one embodiment, a method of measuring a volume of a battery cell according to the present invention is performed by interposing a battery cell in the battery cell jig and then measuring weights before and after a volume change of the battery cell, respectively.

In a specific embodiment, a method of measuring the volume of a battery cell according to the present invention includes: interposing the battery cell in the battery cell jig and then measuring the weight of the battery cell jig in the air; accommodating the battery cell jig in a water tank where liquid has been accommodated, and then measuring the weight of the battery cell jig in the liquid; and calculating a volume change amount of the battery cell by a following formula 1:

[Formula 1]

$$V = \frac{W1 - W2}{\rho}$$

Herein, the V denotes the volume change amount of the battery cell, W1 denotes the weight of the battery cell jig in the air, W2 denotes the weight of the battery cell jig accommodated in liquid, and $\rho$ denotes a density of the liquid.

As described above, the method of measuring the volume of a battery cell according to the present invention uses the principle of Archimedes. Specifically, the difference between the weight of the battery cell before being dipped in the liquid accommodated in the water tank and the weight of the battery cell after being dipped in the liquid may be the weight of the liquid which has increased in volume as the battery cell is dipped in the liquid. At this time, since the weight of the liquid, which is pushed aside as the battery cell is dipped in the liquid, is the same as the buoyancy, the volume of the battery cell can be recognized from the measured buoyancy.

Likewise, according to the battery cell volume measuring method of the present invention, it is possible to measure the volume of a battery cell in a non-destructive manner in a normal pressure by only measuring the weight of the battery cell without a process of punching the battery.

Further, a step of interposing the battery cell in the battery cell jig and then measuring the weight of the battery cell jig in the air is performed. At this time, the battery cell jig having the battery cell interposed therein can measure the weight using a scale such as a spring scale.

Further, the battery cell jig is accommodated in a water tank where liquid has been accommodated. There is no particular limitation to the type of liquid accommodated in the water tank. For example, water can be accommodated. Alternatively, liquid such as ethanol can be used, and electrically insulating liquid such as silicone oil can be used.

In another embodiment, the measuring of the weight of the battery cell jig accommodated in the liquid, includes heating the liquid to a predetermined temperature. In a specific example, the step of measuring the weight of the battery cell jig in the liquid includes a process of charging and discharging the battery cell. In the charging and discharging process, it is possible to activate the battery cell by charging and discharging the battery cell through a charge and discharge unit which is electrically connected to the battery cell.

Further, it is possible to measure the volume of the internal gas which is generated during charge/discharge through the charge/discharge process by measuring the weight of the battery cell accommodated in the liquid.

Thereafter, in the method of measuring the volume of a battery cell according to the present invention, it is possible to calculate the volume change amount of the battery cell by the formula 1 by using the weight of the battery cell measured in the air and the weight of the battery cell measured in the liquid.

In another embodiment, the measuring of the weight of the battery cell jig in the liquid may comprise heating the liquid to a predetermined temperature. Such a process can be performed by a temperature control unit of the battery cell volume measuring apparatus. For example, it can be performed by heating an iron plate surrounding the water tank. Herein, the process of heating the liquid should be performed before the step of measuring the weight of the battery cell accommodated in the liquid. The temperature of liquid can be measured by a temperature measuring unit such as a thermocouple, through which the liquid can be heated up to a predetermined temperature.

As such, the method of measuring the volume of a battery cell according to the present invention further includes a step of calculating the volume change of the battery cell according to the temperature of the liquid. For example, after the temperature of the liquid is set to 45, 60 or 80°C and the volume of the battery cell at this time is measured, respectively, the volume change trend of the battery cell according to the temperature can be derived.

Hereinafter, the present invention will be described in more detail through drawings and the like. As the inventive concept allows for various changes and numerous embodiments, particular embodiments will be illustrated in the drawings and described in detail in the text. However, this is not intended to limit the present invention to the specific form disclosed, and it should be understood to include all changes, equivalents, and substitutes included in the spirit and scope of the present invention.

(First embodiment)

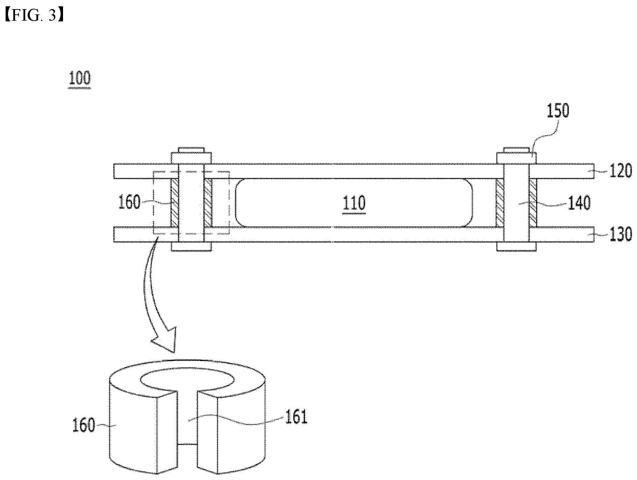

FIG. 3 is a right-side cross-sectional view of a battery cell jig including a spacer according to one embodiment of the present invention.

Referring to FIG. 3, a battery cell jig 100 according to the present invention includes: first and second plates 120 and 130; a bolt 140 and a nut 150 which fix the first and second plates in a state that a battery cell 110 is interposed between the first and second plates 120 and 130; and a spacer 160 which is positioned between the first and second plates to designate a separation distance and have a structure of surrounding the bolt 140. At this time, the spacer 160 includes a slit 161 opened along a longitudinal direction of the spacer 160.

Specifically, the spacer 160 is used to maintain the distance between the first and second plates 120 and 130 constant and has a structure of surrounding the bolt 140. At this time, the slit 161 of the spacer 160 is opened from one side to the other side along the longitudinal direction of the spacer 160. Namely, since the spacer 160 has a structure which is opened along a longitudinal direction, it is possible to prevent water from stagnating in the spacer 160 or gas from being filled in the spacer 160 at the time of measuring the volume of the battery cell 110 using Archimedes principle.

At this time, the spacer 160 has a height corresponding to the height of the battery cell 110 interposed between the first and second plates 120 and 130. As such, it is possible to easily adjust the space between the first and second plates 120 and 130. More specifically, the user allows the battery cell 110 to be positioned on the second plate 130 coupled with the bolt 140, and the spacer 160 is inserted into the bolt 140. Thereafter, the first plate 120 is coupled and is fastened by nuts 150.

The battery cell jig 100 according to the present invention includes a plurality of bolts 140 and nuts 150. Specifically, the battery cell jig 100 according to the present invention includes 4 to 12 bolts 140 and nuts 150, respectively. For example, the battery cell jig 100 includes 10 bolts 140 and nuts 150, respectively. However, the present invention is not limited thereto.

Further, the battery cell jig 100 according to the present invention may have a structure where the spacer 160 is fastened with at least one bolt 140. For example, it is possible to minimize biased pressure or a fastening error, etc. per position by inserting the spacer 160 having the same height into each bolt 140.

(Second embodiment)

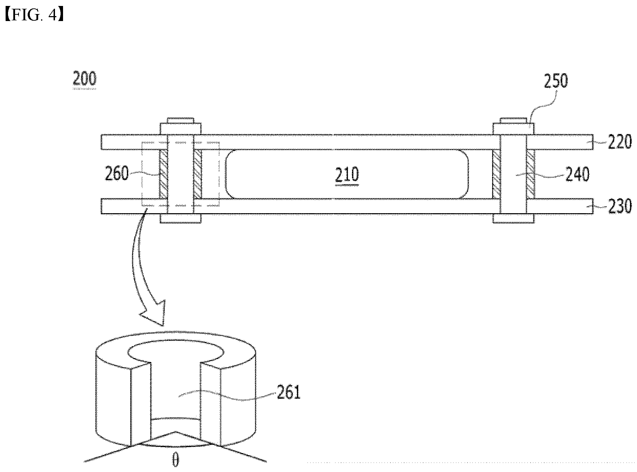

FIG. 4 is a right-side cross-sectional view of a battery cell jig including a spacer according to another embodiment of the present invention.

Referring to FIG. 4, a battery cell jig 200 according to the present invention includes: first and second plates 220 and 230; a bolt 240 and a nut 250 which fix the first and second plates in a state that a battery cell 210 is interposed between the first and second plates 220 and 230; and a spacer 260 which is positioned between the first and second plates to designate a separation distance and have a structure of surrounding the bolt 240. At this time, the spacer 260 includes a slit 261 opened along a longitudinal direction of the spacer 260.

Specifically, the spacer 260 is used to maintain the distance between the first and second plates 220 and 230 constant and has a structure of surrounding the bolt 240. At this time, the slit 261 of the spacer is opened from one side to the other side along the longitudinal direction of the spacer 260.

Specifically, the angle between the slit 261 and the center of the axis is in the range of 10 to 70 degrees($\theta$). The slit 261 of the spacer 260 is opened in a range of 10 to 70 degrees($\theta$) from the center of the axis on the basis of the cross-section of the spacer 260. For example, the slit 261 is opened by 60 degrees on average on the basis of the axis of the spacer 260. Since the slit 261 is opened in the above-mentioned angle, it is possible to prevent water from stagnating or gas from being filled at a space between the battery cell jig 200 and the spacer 260.

Further, it is possible to adjust the space between the first and second plates 220 and 230 by using the spacer 260, and when measuring the volume change of the battery cell 210 using Archimedes principle, it is possible to measure the volume change of the battery cell 210 after the spacer 260 is separated from the battery cell jig 200 because the spacer 260 is opened at the above-described angle.

Since each component has been described above, the detailed description of each component will be omitted here.

(Third embodiment)

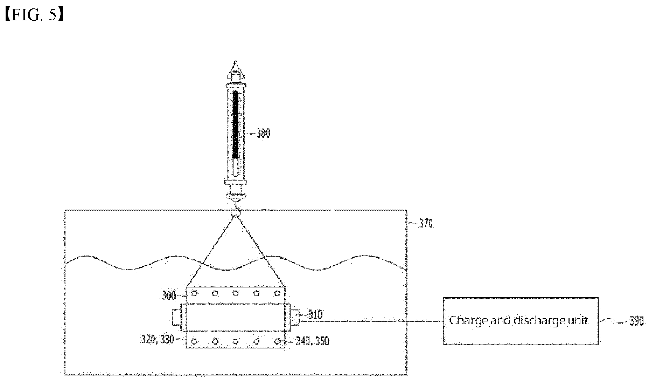

FIG. 5 is a block diagram illustrating each component of a battery cell volume measuring apparatus according to further another embodiment of the present invention.

Referring to FIG. 5, a battery cell volume measuring apparatus according to the present invention includes: the battery cell jig 300; a water tank 370 where liquid is accommodated therein; and a scale 380 which measures a weight of the battery cell jig 300, where the battery cell 310 has been accommodated, at an external side of the water tank 370 and at an internal side of the water tank 370, respectively. The battery cell volume measuring apparatus according to the present invention measures the volume change amount of the battery cell 310 using Archimedes principle. More specifically, the volume change amount of the battery cell 310 can be calculated by calculating the difference between the weight of the battery cell 310 which is measured before being dipped in the liquid accommodated in the water tank 370, and the weight of the battery cell 310 after being dipped in the liquid.

The water tank 370 has a space capable of accommodating liquid therein. There is no particular limitation to the type of liquid accommodated in the water tank 370. For example, water can be accommodated. Alternatively, liquid such as ethanol can be used, and electrically insulating liquid such as silicone oil can be used.

The battery cell jig 300 fixes the battery cell 310 in order to prevent a movement of the battery cell 310 during the volume measurement. As described above, the battery cell jig 300 includes: first and second plates 320 and 330; a bolt 340 and a nut 350 which fix the first and second plates in a state that a battery cell 310 is interposed between the first and second plates 320 and 330; and a spacer (not shown) which is positioned between the first and second plates to designate a separation distance and have a structure of surrounding the bolt 340. At this time, the spacer includes a slit which is opened along a longitudinal direction.

Further, the scale 380 is used to measure the weight of the battery cell jig 300 having the battery cell 310 accommodated therein and measures the weight at the external side of the water tank 370 and the weight in the liquid. Herein, the weight at the external side of the water tank 370 means the weight of the battery cell jig 300 in the air. The scale 380 may be a conventional scale for measuring a weight. For example, the scale 380 may be a spring scale or an electronic scale. In the drawings, a spring scale is illustrated as the scale 380, but the present invention is not limited to this example.

Further, the battery cell volume measuring apparatus further includes a charge and discharge unit 390 which is electrically connected to the battery cell. The charge and discharge unit 390 can activate the battery cell through a charge/discharge which is electrically connected to the electrode assembly of the battery cell 310. At this time, the charge and discharge unit 390 may be electrically connected to the electrode lead of the battery cell 310 through a charge/discharge line (not shown).

Further, it is possible to measure the volume of the internal gas which is generated during charge/-discharge through the charge/discharge process by measuring the weight of the battery cell 310 accommodated in the liquid.

Further, the present invention provides a battery cell volume measuring method performed by using the above-described battery cell volume measuring apparatus. **In** a specific example, a method of measuring a volume of a battery cell according to the present invention is performed by interposing a battery cell in the battery cell jig and then measuring weights before and after a volume change of the battery cell, respectively.

As described above, the method of measuring the volume of a battery cell according to the present invention uses the principle of Archimedes. Hereinafter, the method will be described in detail.

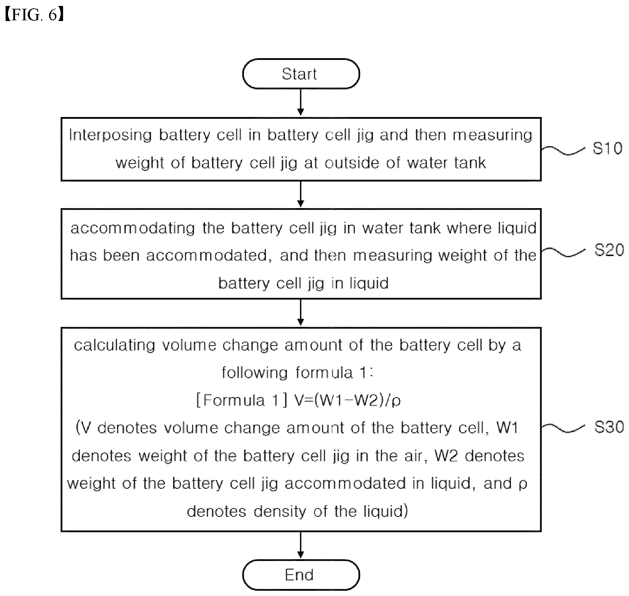

FIG. 6 is a flowchart illustrating a method of measuring the volume of a battery cell according to further another embodiment of the present invention.

Referring to FIG. 6, a method of measuring the volume of a battery cell according to the present invention includes: interposing the battery cell in the battery cell jig and then measuring the weight of the battery cell jig in the air (S10); accommodating the battery cell jig in a water tank where liquid has been accommodated, and then measuring the weight of the battery cell jig in the liquid (S20); and calculating a volume change amount of the battery cell by a following formula 1 (S30):

[Formula 1]

$$V=(W1-W2)/\rho$$

Herein, the V denotes the volume change amount of the battery cell, W1 denotes the weight of the battery cell jig in the air, W2 denotes the weight of the battery cell jig accommodated in liquid, and $\rho$ denotes a density of the liquid.

As described above, the method of measuring the volume of a battery cell according to the present invention uses the principle of Archimedes. Specifically, the difference between the weight of the battery cell before being dipped in the liquid accommodated in the water tank and the weight of the battery cell after being dipped in the liquid may be the weight of the liquid which has increased in volume as the battery cell is dipped in the liquid. At this time, since the weight of the liquid, which is pushed aside as the battery cell is dipped in the liquid, is the same as the buoyancy, the volume of the battery cell can be recognized from the measured buoyancy.

Likewise, according to the battery cell volume measuring method of the present invention, it is possible to measure the volume of a battery cell in a non-destructive manner in a normal pressure by only measuring the weight of the battery cell without a process of punching the battery.

Specifically, the weight W1 of the battery cell jig having the battery cell interposed therein in the air, and after performing a charge/discharge process in a state that the battery cell is dipped in ethanol, the weight W2 of the battery cell jig accommodated in the liquid was measured.

At this time, the weight W1 of the battery cell jig in the air was 110 g, and the weight W2 of the battery cell jig accommodated in the liquid was 100 g. If the density of the ethanol is $\rho= 0.789g/cm^3$ and the volume change amount of the battery cell is V, the weight change amount of the battery cell is the same as the weight of the ethanol pushed aside, and the volume of the ethanol pushed aside is the same of the volume change amount of the battery cell due to gas generation, that is, V. Hence, in summary, ρ is (weight of ethanol pushed aside) / (volume of ethanol pushed aside). At this time, since the volume of the ethanol having been pushed aside is (the weight of the ethanol having been pushed aside)/ρ, V can be can be calculated by (110-100)/0.789. Namely, the volume change amount of the battery cell is about 12.674 cm$^3$.

In the above, the present invention has been described in more detail through the drawings and examples. Accordingly, the embodiments described in the specification and the configurations described in the drawings are only the most preferred embodiments of the present invention, the scope of which being defined by the appended claims.

[Description of reference numerals]

10, 100, 200, 300: battery cell jig
11, 110, 210, 310: battery cell
12, 120, 220, 320: first plate
13, 130, 230, 330: second plate
14, 140, 240, 340: bolt
15, 150, 250, 350: nut
16, 160, 260: spacer
161, 261: slit
370: water tank
380: scale
390: charge and discharge unit

**Claims**

1. An apparatus for measuring a volume of a battery cell (110, 210, 310), comprising:

   a water tank (370) where liquid is accommodated therein; and
   a scale (380) configured to measure a weight of a battery cell jig (100, 200, 300), wherein the battery cell (110, 210, 310) has been accommodated, at an external side of the water tank (370) and at an internal side of the water tank (370), respectively.
   the battery cell jig (100, 200, 300) comprising:

   first and second plates (120, 130, 220, 230, 320, 330);
   a bolt (140, 240, 340) and a nut (150, 250, 350) which fix the first and second plates (120, 130, 220, 230, 320, 330) in a state that a battery cell (110, 210, 310) is interposed between the first and second plates (120, 130, 220, 230, 320, 330); and
   a spacer (160, 260) which is positioned between the first and second plates (120, 130, 220, 230, 320, 330) to designate a separation distance and have a structure of surrounding the bolt (140, 240, 340), wherein the spacer (160, 260) includes a slit which is opened along a longitudinal direction of the spacer (160, 260).

2. The apparatus of claim 1, wherein the slit of the spacer (160, 260) is opened from one side to the other side along the longitudinal direction.

3. The apparatus of claim 1, wherein the slit of the spacer (160, 260) is opened in a range of 10 to 70 degrees from a center of an axis.

4. The apparatus of claim 1, wherein a height of the spacer (160, 260) corresponds to a height of a battery cell (110, 210, 310) interposed between the first and second plates (120, 130, 220, 230, 320, 330).

5. The apparatus of claim 1, wherein the battery cell jig (100, 200, 300) includes 4 to 12 bolts (140, 240, 340) and nuts (150, 250, 350), respectively, and
   wherein the spacer (160, 260) is fastened by at least one bolt (140, 240, 340).

6. The apparatus of claim 1, further comprising a charge and discharge unit (390) which is electrically connected to the battery cell (110, 210, 310).

7. A method of measuring a volume of a battery cell (110, 210, 310) by interposing a battery cell (110, 210, 310) in the apparatus including the battery cell jig (100, 200, 300) according to claim 1 and then measuring weights before and after a volume change of the battery cell (110, 210, 310), respectively.

8. The method of claim 7, comprising:

   interposing the battery cell (110, 210, 310) in the battery cell jig (100, 200, 300) and then measuring the weight of the battery cell jig (100, 200, 300) in the air;
   accommodating the battery cell jig (100, 200, 300) in a water tank (370) where liquid has been accommodated, and then measuring the weight of the battery cell jig (100, 200, 300) in the liquid; and
   calculating a volume change amount of the battery cell (110, 210, 310) by a following formula 1:

[Formula 1]

$$V = \frac{W1 - W2}{\rho},$$

wherein in Formula 1, V denotes the volume change amount of the battery cell (110, 210, 310), W1 denotes the weight of the battery cell jig (100, 200, 300) in the air, W2 denotes the weight of the battery cell jig (100, 200, 300) accommodated in liquid, and $\rho$ denotes a density of the liquid.

9. The method of claim 8, wherein the measuring the weight of the battery cell jig (100, 200, 300) in the liquid comprises charging and discharging the battery cell (110, 210, 310).

10. The method of claim 8, wherein during the measuring of the weight of the battery cell jig (100, 200, 300) in the air and the measuring of the weight of the battery cell jig (100, 200, 300) in the liquid, the weight of the battery cell jig (100, 200, 300) is measured by using a spring scale (380).

11. The method of claim 8, wherein the measuring the weight of the battery cell jig (100, 200, 300) in the liquid may comprise heating the liquid to a predetermined temperature.

12. The method of claim 8, wherein the calculating a volume change amount of the battery cell (110, 210, 310) may comprise calculating a volume change of the battery cell (110, 210, 310) according to a temperature of the liquid.

13. The method of claim 8, wherein the liquid accommodated in the water tank (370) comprises water, ethanol or silicone oil.


**Patentansprüche**

1. Vorrichtung zum Messen des Volumens einer Batteriezelle (110, 210, 310), umfassend:

   einen Wassertank (370), in dem Flüssigkeit untergebracht ist; und
   eine Waage (380), zum Messen eines Gewicht einer Batteriezellen-Haltevorrichtung (100, 200, 300), in der die Batteriezelle (110, 210, 310) untergebracht ist, jeweils an einer Außenseite des Wassertanks (370) und an einer Innenseite des Wassertanks (370),
   die Batteriezellen-Haltevorrichtung (100, 200, 300) umfasst:

   eine erste und eine zweite Platte (120, 130, 220, 230, 320, 330);
   einen Bolzen (140, 240, 340) und eine Mutter (150, 250, 350), die die erste und die zweite Platte (120, 130, 220, 230, 320, 330) in einem Zustand fixieren, in dem eine Batteriezelle (110, 210, 310) zwischen der ersten und der zweiten Platte (120, 130, 220, 230, 320, 330) angeordnet ist; und
einen Abstandshalter (160, 260), der zwischen der ersten und der zweiten Platte (120, 130, 220, 230, 320, 330) angeordnet ist, um einen Trennungsabstand zu bezeichnen, und eine Struktur aufweist, die den Bolzen (140, 240, 340) umgibt,
wobei der Abstandshalter (160, 260) einen entlang einer Längsrichtung des Abstandshalters (160, 260) geöffneten Schlitz aufweist.

2. Vorrichtung nach Anspruch 1, wobei der Schlitz des Abstandshalters (160, 260) entlang der Längsrichtung von einer Seite zur anderen Seite offen ist.

3. Vorrichtung nach Anspruch 1, bei der der Schlitz des Abstandshalters (160, 260) in einem Bereich von 10 bis 70 Grad um ein Achsenzentrum offen ist.

4. Vorrichtung nach Anspruch 1, wobei eine Höhe des Abstandshalters (160, 260) einer Höhe einer zwischen der ersten und der zweiten Platte (120, 130, 220, 230, 320, 330) angeordneten Batteriezelle (110, 210, 310) entspricht.

5. Vorrichtung nach Anspruch 1, wobei die Batteriezellen-Haltevorrichtung (100, 200, 300) 4 bis 12 Bolzen (140, 240, 340) bzw. Muttern (150, 250, 350) umfasst, und wobei der Abstandshalter (160, 260) durch wenigstens einen Bolzen (140, 240, 340) befestigt ist.

6. Vorrichtung nach Anspruch 1, ferner umfassend eine elektrisch mit der Batteriezelle (110, 210, 310) verbundene Lade- und Entladeeinheit (390).

7. Verfahren zum Messen des Volumens einer Batteriezelle (110, 210, 310) durch Einsetzen einer Batteriezelle (110, 210, 310) in die Vorrichtung mit der Batteriezellen-Haltevorrichtung (100, 200, 300) nach Anspruch 1 und anschließendes Messen der Gewichte vor und nach einer Volumenänderung der Batteriezelle (110, 210, 310).

8. Verfahren nach Anspruch 7, umfassend:

   Einsetzen der Batteriezelle (110, 210, 310) in die Batteriezellen-Haltevorrichtung (100, 200, 300) und anschließendes Messen des Gewichts der Batteriezellen-Haltevorrichtung (100, 200, 300) in der Luft;
   Unterbringen der Batteriezellenhalterung (100, 200, 300) in einem Wassertank (370), in dem Flüssigkeit untergebracht ist, und anschließendes Messen des Gewichts der Batteriezellenhalterung (100, 200, 300) in der Flüssigkeit; und Berechnen einer Volumenveränderungsmenge der Batteriezelle (110, 210, 310) durch eine folgende Formel 1:

$$[Formel\ 1]$$

$$V = \frac{W1 - W2}{\rho},$$

wobei in Formel 1 V den Volumenänderungsbetrag der Batteriezelle (110, 210, 310) bezeichnet, W1 das Gewicht der Batteriezellen-Haltevorrichtung (100, 200, 300) in der Luft bezeichnet, W2 das Gewicht der Batteriezellen-Haltevorrichtung (100, 200, 300) bezeichnet, die in der Flüssigkeit untergebracht ist, und $\rho$ eine Dichte der Flüssigkeit bezeichnet.

9. Verfahren nach Anspruch 8, wobei die Messung des Gewichts der Batteriezellen-Haltevorrichtung (100, 200, 300) in der Flüssigkeit das Laden und Entladen der Batteriezelle (110, 210, 310) umfasst.

10. Verfahren nach Anspruch 8, wobei während der Messung des Gewichts der Batteriezellen-Haltevorrichtung (100, 200, 300) in der Luft und der Messung des Gewichts der Batteriezellen-Haltevorrichtung (100, 200, 300) in der Flüssigkeit das Gewicht der Batteriezellen-Haltevorrichtung (100, 200, 300) unter Verwendung einer Federwaage (380) gemessen wird.

11. Verfahren nach Anspruch 8, wobei das Messen des Gewichts der Batteriezellen-Haltevorrichtung (100, 200, 300) in der Flüssigkeit das Erwärmen der Flüssigkeit auf eine vorbestimmte Temperatur umfassen kann.

12. Verfahren nach Anspruch 8, wobei das Berechnen einer Volumenänderung der Batteriezelle (110, 210, 310) das Berechnen einer Volumenänderung der Batteriezelle (110, 210, 310) in Abhängigkeit von einer Temperatur der Flüssigkeit umfassen kann.

13. Verfahren nach Anspruch 8, wobei die in dem Wassertank (370) untergebrachte Flüssigkeit Wasser, Ethanol oder Silikonöl umfasst.

## Revendications

1. Appareil destiné à mesurer un volume d'un élément de batterie (110, 210, 310), comprenant :

     un réservoir d'eau (370) où est placé un liquide ; et

une balance (380) configurée pour mesurer un poids d'un dispositif de montage d'élément de batterie (100, 200, 300), dans lequel l'élément de batterie (110, 210, 310) a été placé, à un côté externe du réservoir d'eau (370) et à un côté interne du réservoir d'eau (370), respectivement,
le dispositif de montage d'élément de batterie (100, 200, 300) comprenant :

     des premières et deuxièmes plaques (120, 130, 220, 230, 320, 330) ;
     un boulon (140, 240, 340) et un écrou (150, 250, 350) qui fixent les premières et deuxièmes plaques (120, 130, 220, 230, 320, 330) dans un état où un élément de batterie (110, 210, 310) est interposé entre les premières et deuxièmes plaques (120, 130, 220, 230, 320, 330) ; et
     un espaceur (160, 260) qui est positionné entre les premières et deuxièmes plaques (120, 130, 220, 230, 320, 330) pour désigner une distance de séparation et avoir une structure entourant le boulon (140, 240, 340),
     dans lequel l'espaceur (160, 260) inclut une fente qui est ouverte le long d'une direction longitudinale de l'espaceur (160, 260).

2. Appareil selon la revendication 1, dans lequel la fente de l'espaceur (160, 260) est ouverte d'un côté à l'autre côté le long de la direction longitudinale.

3. Appareil selon la revendication 1, dans lequel la fente de l'espaceur (160, 260) est ouverte dans une plage de 10 à 70 degrés à partir d'un centre d'un axe.

4. Appareil selon la revendication 1, dans lequel une hauteur de l'espaceur (160, 260) correspond à une hauteur d'un élément de batterie (110, 210, 310) interposé entre les premières et deuxièmes plaques (120, 130, 220, 230, 320, 330).

5. Appareil selon la revendication 1, dans lequel le dispositif de montage d'élément de batterie (100, 200, 300) inclut 4 à 12 boulons (140, 240, 340) et écrous (150, 250, 350), respectivement, et
dans lequel l'espaceur (160, 260) est fixé par au moins un boulon (140, 240, 340).

6. Appareil selon la revendication 1, comprenant en outre une unité de charge et décharge (390) qui est reliée électriquement à l'élément de batterie (110, 210, 310).

7. Procédé de mesure d'un volume d'un élément de batterie (110, 210, 310) en interposant un élément de batterie (110, 210, 310) dans l'appareil incluant le dispositif de montage d'élément de batterie (100, 200, 300) selon la revendication 1, puis en mesurant les poids avant et après un changement de volume de l'élément de batterie (110, 210, 310), respectivement.

8.  Procédé selon la revendication 7, consistant à :

    interposer l'élément de batterie (110, 210, 310) dans le dispositif de montage d'élément de batterie (100, 200, 300), puis mesurer le poids du dispositif de montage d'élément de batterie (100, 200, 300) dans l'air ;
    placer le dispositif de montage d'élément de batterie (100, 200, 300) dans un réservoir d'eau (370) où un liquide a été placé, puis mesurer le poids du dispositif de montage d'élément de batterie (100, 200, 300) dans le liquide ; et
    calculer une quantité de changement de volume de l'élément de batterie (110, 210, 310) par la formule 1 ci-après :

    [Formule 1]

    $$V = \frac{W1 - W2}{\rho},$$

    dans lequel dans la Formule 1, V indique la quantité de changement de volume de l'élément de batterie (110, 210, 310), W1 indique le poids du dispositif de montage d'élément de batterie (100, 200, 300) dans l'air, W2 indique le poids du dispositif de montage d'élément de batterie (100, 200, 300) placé dans le liquide et $\rho$ indique une densité du liquide.

9.  Procédé selon la revendication 8, dans lequel la mesure du poids du dispositif de montage d'élément de batterie (100, 200, 300) dans le liquide comprend la charge et la décharge de l'élément de batterie (110, 210, 310).

10. Procédé selon la revendication 8, dans lequel, pendant la mesure du poids du dispositif de montage d'élément de batterie (100, 200, 300) dans l'air et la mesure du poids du dispositif de montage d'élément de batterie (100, 200, 300) dans le liquide, le poids du dispositif de montage d'élément de batterie (100, 200, 300) est mesuré en utilisant une balance à ressort (380).

11. Procédé selon la revendication 8, dans lequel la mesure le poids du dispositif de montage d'élément de batterie (100, 200, 300) dans le liquide peut comprendre le chauffage du liquide à une température prédéterminée.

12. Procédé selon la revendication 8, dans lequel le calcul d'une quantité de changement de volume de l'élément de batterie (110, 210, 310) peut comprendre le calcul d'un changement de volume de l'élément de batterie (110, 210, 310) en fonction d'une température du liquide.

13. Procédé selon la revendication 8, dans lequel le liquide placé dans le réservoir d'eau (370) comprend l'eau, l'éthanol ou l'huile de silicone.

【FIG. 1】

【FIG. 2】

【FIG. 3】

【FIG. 4】

【FIG. 5】

【FIG. 6】

```
        ┌─────────────┐
        │    Start    │
        └──────┬──────┘
               │
               ▼
┌──────────────────────────────────────────────┐
│ Interposing battery cell in battery cell jig  │        S10
│ and then measuring weight of battery cell jig  │
│ at outside of water tank                       │
└──────────────────┬─────────────────────────────┘
                   │
                   ▼
┌──────────────────────────────────────────────┐
│ accommodating the battery cell jig in water    │
│ tank where liquid has been accommodated, and   │        S20
│ then measuring weight of the battery cell jig  │
│ in liquid                                      │
└──────────────────┬─────────────────────────────┘
                   │
                   ▼
┌──────────────────────────────────────────────┐
│ calculating volume change amount of the        │
│ battery cell by a following formula 1:         │
│ [Formula 1] V=(W1-W2)/ρ                        │
│ (V denotes volume change amount of the         │        S30
│ battery cell, W1 denotes weight of the battery │
│ cell jig in the air, W2 denotes weight of the  │
│ battery cell jig accommodated in liquid, and ρ │
│ denotes density of the liquid)                 │
└──────────────────┬─────────────────────────────┘
                   │
                   ▼
        ┌─────────────┐
        │     End     │
        └─────────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020200125775

- KR 100922571 B1